(19) Europäisches Patentamt
European Patent Office
Office européen des brevets

(11) **EP 4 446 691 A1**

(12) **EUROPEAN PATENT APPLICATION**
published in accordance with Art. 153(4) EPC

(43) Date of publication:
**16.10.2024 Bulletin 2024/42**

(21) Application number: **22902718.0**

(22) Date of filing: **10.05.2022**

(51) International Patent Classification (IPC):
***G01B 7/00*** (2006.01)

(52) Cooperative Patent Classification (CPC):
**H02J 3/00125; G01B 7/00; G01R 19/2513;**
**G01R 31/085; H02J 3/0012; H02J 13/00002;**
**H02J 13/00032;** H02J 13/0001

(86) International application number:
**PCT/CN2022/092079**

(87) International publication number:
**WO 2023/103278 (15.06.2023 Gazette 2023/24)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **06.12.2021 CN 202111479145**
**06.12.2021 CN 202111477325**
**06.12.2021 CN 202111511459**
**06.12.2021 CN 202111511460**

(71) Applicant: **Tsinghua University**
**Beijing 100084 (CN)**

(72) Inventors:
• **ZHANG, Bo**
**Beijing 100084 (CN)**
• **CUI, Zherui**
**Beijing 100084 (CN)**
• **ZHANG, Zhecheng**
**Beijing 100084 (CN)**
• **HU, Jun**
**Beijing 100084 (CN)**
• **HE, Jinliang**
**Beijing 100084 (CN)**

(74) Representative: **Petraz, Gilberto Luigi et al**
**GLP S.r.l.**
**Viale Europa Unita, 171**
**33100 Udine (IT)**

(54) **ONLINE MONITORING METHOD FOR POSITION INFORMATION OF CONDUCTING WIRE OF POWER TRANSMISSION LINE BASED ON ELECTROMAGNETIC SIGNAL OF GROUND WIRE**

(57) An online monitoring method for position information of a conducting wire of a power transmission line based on an electromagnetic signal of a ground wire. The method comprises: mounting a voltage or current measurement apparatus on a ground wire of an overhead line, and measuring, in real time, an induced voltage or induced current on the ground wire in combination with a matched data processing and communication module (101); when the induced voltage or induced current changes, sending, after the determination of a related module and to a data processing end, induced voltage or induced current values of the ground wire before and after the change (102); deducing a mutual inductance change condition between a conducting wire and the ground wire in combination with the magnitude of a line running current and a collected change condition in the electromagnetic signal of the ground wire, and further deducing a position change condition of the conducting wire on this basis (103); and performing online monitoring on a position phenomenon and a motion state of the con-

ducting wire of a power transmission line according to the position change condition of the conducting wire (104). The problems of more sensors, high cost and mounting difficulty involved in the existing method are solved, thereby improving the feasibility, and reducing the cost.

FIG. 1

**Description**

**TECHNICAL FIELD**

The disclosure relates to the field of high voltage engineering technology, in particularly, to an online monitoring method for position information of transmission line conductors based on electromagnetic signals of ground wires, and an apparatus thereof.

**BACKGROUND**

Transmission line conductors are a failure prone part due to severe geographic conditions, climate changes in a natural environment, and face problems arising from technological innovations on transmission lines by humans. The problems include conductor ice-over, a conductor offset caused by windage, conductor galloping, a high conductor temperature caused by an increase in a transmission capacity of the transmission line, as well as increase in a sag of the transmission line.

The conductor ice-over mainly includes two types: rime and silver thaw. Generally, the rime is less dense and not tight frozen. The silver thaw is dense and has strong adhesion capacity, and also tends to form the ice coating around the conductors, which often causes excessive stress on the conductors, icing flashover, galloping, ice-shedding and other phenomena, thereby seriously affecting a normal operation of the transmission line. For example, ice disaster causes a large number of broken transmission lines and collapsed transmission towers. Therefore, a discussion on an issue of the conductor ice-over mainly focuses on the situation of silver thaw.

The offset caused by windage refers to a phenomenon that the transmission line conductors deviate from its original vertical position under an action of wind, which mainly includes a jumper wire offset caused by windage, an interphase offset caused by windage, or an insulator offset caused by windage. The conductor offset caused by windage is different from the conductor galloping. When a wind speed is too large or too small, the conductor generally does not gallop. For the offset caused by windage, the greater the wind speed, the more serious the phenomenon of the offset caused by windage will be. The offset caused by windage may result in a small distance between the conductors or between the conductor and a tower, and further result in flashover or a tripping fault. Due to the continuity of wind, reclosure generally cannot be successfully performed after the flashover or the tripping fault under the situation of offset caused by windage, which may lead to transmission line outages, and bring great harm to a safe operation of a power system.

The conductor galloping, which is an abnormal movement state of the conductors, is mainly manifested as a vibration phenomenon with a low frequency and a large amplitude, accompanied by conductor twisting. The conductor galloping may cause great harm to the transmission line, for example, generally causing short-circuit fault due to line collision and flashover tripping or causing wear and tear of conductor clamps, breakage of phase spacer, shedding of jump wire, loose and detaching of tower bolts, damage of tower frame, etc., which may bring a huge challenge to a safe and stable operation of the power system.

People's production and life demands for electricity is increasing as rapid development of economy and society. Some transmission lines are restricted by the existing technical specification of the transmission line, which seriously limits an increase of power transmission capacity. To solve this problem, relevant experts have proposed a solution to increase a transmission capacity of the transmission line, which breaks through the existing technical specification of the transmission line, and improves a permitted operating temperature of the conductors by 10-20°C, and further increase the transmission capacity of the transmission line for electrical energy transmission. However, as the temperature of the transmission line rises, the conductors will expansion and further the conductor sag will increase. An excessive conductor sag may endanger the normal operation of the transmission line and affect safety of surrounding things.

For the above problems occurred during the operation of the transmission line, there are some corresponding technical solutions, but the related solutions are not suitable for field applications due to low accuracy, high cost, difficult installation and maintenance, and various problems. The specific problems are provided as follows.

For online monitoring a thickness of ice covering the conductor in the overhead transmission line in real time, a common monitoring method is to obtain live video images by using surveillance cameras, and then monitor the ice-over situation of the transmission line. Disadvantages of the method include followings: a. a short monitorable distance; b. the thickness of the ice covering the conductor only being estimated roughly, rather than determined directly; and, c. restricted power supplying issues.

An existing common monitoring method for the line sag is to install a plurality of tension sensors on the conductors, and determine the conductor sag situation of the transmission line by means of mechanical analysis. However, this method involves a plurality of sensors, has high cost and difficult installation, as well as complex calculation principle and may affect the normal operation of the transmission line in case of sensor failure.

An existing online monitoring method for the offset caused by windage of the overhead transmission line is to install motion sensors on the conductors. However, the above method has problems of, for example, installing a large number of sensors, stopping a power supplying operation during installation and maintenance, and difficultly supplying power for monitoring devices.

An existing video monitoring method is generally used to observe the conductor galloping of the transmission line. However, images may be difficult to be captured under a situation of poor regional environment or bad signals, and capturing of real-time states may be influenced due to a low resolution of the captured images in the video.

## SUMMARY

Embodiments of the present disclosure provides an online monitoring method for position information of transmission line conductors based on electromagnetic signals of ground wires and an apparatus thereof, which may online monitor conductor galloping, conductor ice-over, a conductor offset caused by windage, and a conductor sag change caused by a dynamic increase in a transmission capacity of the transmission line. With online monitoring the transmission line, failures or hidden dangers of the transmission line can be rapidly recognized and located, which is of great significance for improving safety, reliability and stability of a power system.

In a first aspect, an embodiment of the present disclosure provides an online monitoring method for position information of transmission line conductors based on electromagnetic signals of ground wires. The method includes: monitoring ground wire induced potentials or ground wire induced currents in real time by voltage monitoring devices or current monitoring devices on ground wires of an overhead transmission line in combination with matched data processing and communication modules; in response to changing in the ground wire induced potentials or the ground wire induced currents, sending values of the ground wire induced potentials or the ground wire induced currents before and after changing to a data processing end, after determination of a related module; deducing change situations of mutual inductances between the ground wires and the conductors based on values of line operation currents and change situations of electromagnetic signals of the ground wires, and further deducing position change situations of the conductors based on the change situations of the mutual inductances between the ground wires and the conductors; and online monitoring position information and movement statuses of the transmission line conductors based on the position change situations of the conductors.

In the technical solution, the ground wire induced potentials or the ground wire induced currents are monitored in real time by the voltage monitoring devices or the current monitoring devices on the ground wires of the overhead transmission line in combination with the matched data processing and communication modules; in response to changing in the ground wire induced potentials or the ground wire induced currents, values of the ground wire induced potentials or the ground wire induced currents before and after changing are sent to the data processing end, after determination of a related module; the change situations of mutual inductances between the ground wires and the conductors are deduced based on the values of line operation currents and the change situations of electromagnetic signals of the ground wires, and the position change situations of the conductors are further deduced based on the change situations of the mutual inductances between the ground wires and the conductors; and the position information and the movement statuses of the transmission line conductors are online monitored based on the position change situations of the conductors. Therefore, the present disclosure can solve problems of large number of sensors, unsatisfactory monitoring effect, high cost, difficult installation and maintenance in the existing methods, and may also solve problems of a complex calculation principle and affecting a normal operation of the transmission line in case of sensor failures in the existing method, and may determine changes in positions and movement statuses of the conductors based on information about the electromagnetic signals of the ground wires and the conductor currents. Meanwhile, the method can realize self-powered online monitoring of the transmission line statuses without any additional power source by online harvesting power from power frequency electromagnetic induced potentials or currents of the ground wires. The method of the present disclosure uses devices with a small installation volume, and has a low cost of failure and has no influence on the normal operation of the transmission line in case of the failure. The present disclosure provides the online monitoring method for the overhead transmission line conductors based on the induced potential of a segmented insulated ground wire or the induced current of an optical fiber composite overhead ground wire (OPGW), which has advantages of simple principle, low cost, easy installation and maintenance, and high feasibility.

In an implementation, the position change situation of the conductor includes:
a conductor sag change situation, or a conductor offset situation caused by windage.

In an optional implementation, online monitoring the conductor sag change situation includes:

analyzing and determining the change situations of the mutual inductances between the ground wires and the conductors by comprehensively considering change situations of conductor currents and the change situations of the monitored ground wire induced potentials or the monitored ground wire induced currents;
deducing change situations of distances between the ground wires and the conductors based on the change situations of the mutual inductances between the ground wires and the conductors;

3

obtaining the conductor sag change situation by further refining based on the change situations of the distances between the ground wires and the conductors; and

determining based on the conductor sag change situation, and generating an alarm when a conductor maximum sag is greater than a preset threshold.

In a possible implementation, a cause of the conductor sag change situation includes increase in transmission capacity of transmission line or conductor ice-over.

In an optional implementation, when the cause of the conductor sag change situation is the conductor ice-over, the method further includes:

on the basic of considering conductor deformation, obtaining a relationship between horizontal stress and thickness of ice covering the conductor and a relationship between the conductor maximum sag and the thickness of ice covering the conductor by analyzing an influence of an ice gravity respectively on a ratio of a conductor load per unit length to a conductor cross-sectional area, the horizontal stress, and the maximum sag.

Optionally, online monitoring the conductor offset situation caused by windage includes:

analyzing and determining the change situations of the mutual inductances between the ground wires and the conductors based on the change situations of the monitored ground wire induced potentials or the monitored ground wire induced currents;

obtaining change situations of distances between the ground wires and the conductors based on the change situations of the mutual inductances between the ground wires and the conductors;

obtaining a spatial position change situation of each conductor by further refining based on the change situations of the distances between the ground wires and the conductors;

deducing the conductor offset situation caused by windage based on the spatial position change situation of the conductor; and

determining based on the conductor offset situation caused by windage, and generating an alarm when a conductor maximum offset is greater than a preset threshold.

In a possible implementation, the method further includes:

supplying power to the monitoring devices by utilizing the ground wire induced potentials or the ground wire induced currents, to achieve self-power.

In an optional implementation, the method further includes: online monitoring and locating a galloping situation of the transmission line, in which online monitoring and locating the galloping situation of the transmission line includes:

step S1: obtaining relevant parameters of the overhead transmission line and establishing an equivalent circuit of the ground wires based on the relevant parameters;

step S2: monitoring the electromagnetic signals of the ground wires in real time and performing spectrum analysis on the electromagnetic signals;

step S3: when a frequency abnormal signal is present in the spectrum analysis, sending the frequency abnormal signal to the data processing end and generating an analysis result;

step S4: determining a frequency, a position and an amplitude of galloping of the transmission line based on the analysis result; and

step S5: executing steps S2, S3, and S4 repeatedly and continuously, and generating an alarm when the calculated amplitude of the galloping being greater than a preset threshold.

In this technical solution, the equivalent circuits of the ground wires are established by obtaining the relevant parameters of the overhead transmission line, and the ground wire induced currents or the ground wire induced potentials are further monitored in real time. Locating the galloping of the transmission line may be achieved. There is no need to install the monitoring devices span by span during locating the galloping of the transmission line, and cost of monitoring and locating the galloping of the transmission line are greatly reduced.

Optionally, determining the frequency, the position and the amplitude of the galloping of the transmission line based on the analysis result includes:

determining the frequency of the conductor galloping;

obtaining phase information of a signal frequency component generated by the corresponding galloping based on the frequency of the conductor galloping;

determining the position of the galloping of the transmission line based on the phase information; and

calculating the amplitude of the galloping based on the position of the galloping of the transmission line and the monitored electromagnetic signals of the ground wires.

In a second aspect, the disclosure provides a non-transitory computer readable storage medium. When instructions are executed by a processor, the method as described in the first aspect is implemented.

## BRIEF DESCRIPTION OF THE DRAWINGS

In order to more clearly illustrate the technical solution in the embodiments of the disclosure or the background technologies, the accompanying drawings that are required to be used in the embodiments of the disclosure or the background technologies are described below.

FIG. 1 is a flowchart illustrating an online monitoring method for position information of transmission line conductors based on electromagnetic signals of ground wires proposed by an embodiment of the disclosure.

FIG. 2 is a schematic diagram illustrating a ground wire induction principle proposed by an embodiment of the disclosure.

FIG. 3 is a schematic diagram illustrating a monitoring solution proposed by an embodiment of the disclosure.

FIG. 4 is a schematic diagram illustrating a method of calculating a conductor sag proposed by an embodiment of the disclosure.

FIG. 5 is a schematic diagram illustrating a relationship between a conductor maximum sag and thickness of ice covering a conductor as well as a relationship between horizontal stress of a conductor with thickness of ice covering a conductor proposed by an embodiment of the disclosure.

FIG. 6 is a schematic diagram illustrating change situations of a conductor sag under different thickness of ice covering a conductor proposed by an embodiment of the disclosure.

FIG. 7 is a schematic diagram illustrating a change of a ground wire induced current with thickness of ice covering a conductor proposed by an embodiment of the disclosure.

FIG. 8 is a schematic diagram illustrating a sag monitoring method based on electromagnetic signals of ground wires in a case of dynamic increase in transmission capacity of a transmission line proposed by an embodiment of the disclosure.

FIG. 9 is a schematic diagram illustrating an influence of a conductor sag in a ground wire induced current when monitoring a conductor sag based on electromagnetic signals of ground wires in case of dynamic increase in transmission capacity of transmission line under different conductor phase currents proposed by an embodiment of the disclosure.

FIG. 10 is a schematic diagram illustrating an influence of a conductor sag in a potential of a ground wire insulator when monitoring a conductor sag based on electromagnetic signals of ground wires in case of dynamic increase in transmission capacity of transmission line under different conductor phase currents proposed by an embodiment of the disclosure.

FIG. 11 is a schematic diagram illustrating a method for calculating a spatial position of a conductor in case of monitoring a conductor offset caused by windage proposed by an embodiment of the disclosure.

FIG. 12 is a schematic diagram illustrating a change of a ground wire induced current with a degree of an offset caused by windage proposed by an embodiment of the disclosure.

FIG. 13 is a flowchart illustrating a method for locating conductor galloping of an overhead transmission line based on electromagnetic signals of ground wires proposed by an embodiment of the disclosure.

FIG. 14 is a schematic diagram illustrating an induced potential waveform on a segmented insulated ground wire during conductor galloping proposed by an embodiment of the disclosure.

FIG. 15 is a schematic diagram illustrating an induced current waveform on an OPGW during conductor galloping proposed by an embodiment of the disclosure.

FIG. 16 is a schematic diagram illustrating a relationship between a galloping-related frequency component and a galloping amplitude proposed by an embodiment of the disclosure.

FIG. 17 is a schematic diagram illustrating a relationship between a measurement positon and a current phase difference proposed by an embodiment of the disclosure.

FIG. 18 is a schematic diagram illustrating an amplitude decrease law when a galloping-related frequency component propagates along a ground wire proposed by an embodiment of the disclosure.

FIG. 19 is a schematic diagram illustrating a locating method for multi-span galloping proposed by an embodiment of the disclosure.

FIG. 20 is a schematic diagram illustrating a locating algorithm for galloping of an overhead transmission line based on electromagnetic signals of ground wires proposed by an embodiment of the disclosure.

## DETAILED DESCRIPTION

Embodiments of the disclosure are described in detail below, and examples of the embodiments are shown in the accompanying drawings, in which the same or similar numbers indicate the same or similar components or components having the same or similar function. The embodiments described below with reference to the accompanying drawings are exemplary and are intended only to explain the disclosure and are not to be used for limiting the disclosure.

An online monitoring method for position information of transmission line conductors based on electromagnetic signals of ground wires and an apparatus thereof are described below with reference to the accompanying drawings.

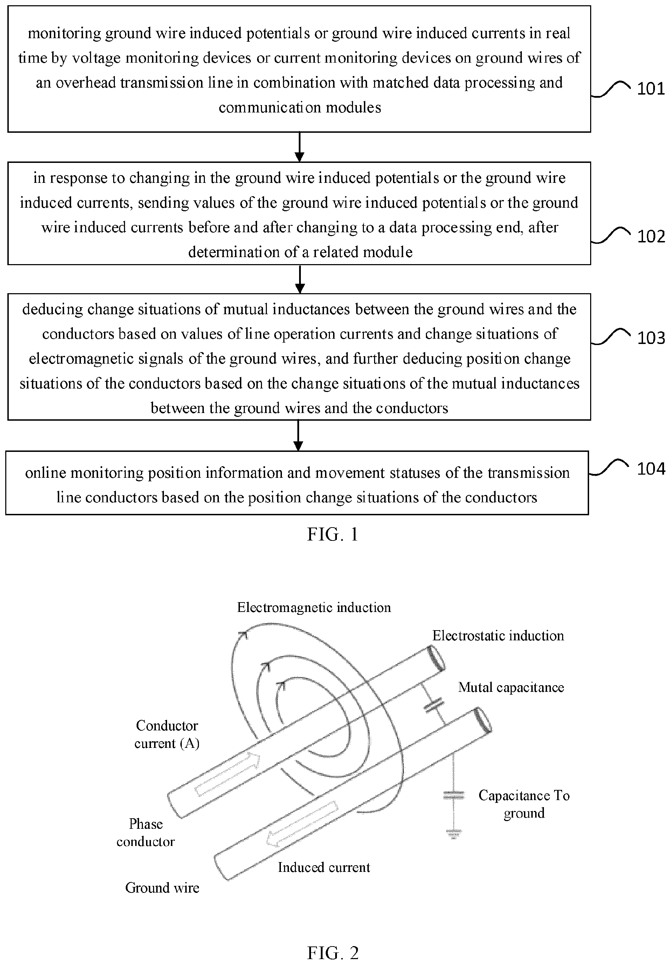

FIG. 1 is a flowchart illustrating an online monitoring method for position information of transmission line conductors based on electromagnetic signals of ground wires proposed by an embodiment of the disclosure.

As shown in FIG. 1, the method includes the following steps.

At step 101, ground wire induced voltages or ground wire induced currents are monitored in real time by voltage monitoring devices or current monitoring devices on ground wires of an overhead transmission line in combination with matched data processing and communication modules.

At step 102, in response to changing in the ground wire induced potentials or the ground wire induced currents, values of the ground wire induced potentials or the ground wire induced currents before and after changing are sent to a data processing end, after determination of a related module.

At step 103, change situations of mutual inductances between the ground wires and the conductors are deduced based on values of line operation currents and change situations of electromagnetic signals of the ground wires, and position change situations of the conductors are further deduced based on the change situations of the mutual inductances between the ground wires and the conductors.

At step 104, position information and movement statuses of the transmission line conductors are online monitored based on the position change situations of the conductors.

According to the method in embodiments of the present disclosure, the ground wire induced potentials or the ground wire induced currents are monitored in real time by the voltage monitoring devices or the current monitoring devices on the ground wires of the overhead transmission line in combination with the matched data processing and communication modules; in response to changing in the ground wire induced potentials or the ground wire induced currents, values of the ground wire induced potentials or the ground wire induced currents before and after changing are sent to the data processing end, after determination of a related module; the change situations of mutual inductances between the ground wires and the conductors are deduced based on the values of line operation currents and the change situations of electromagnetic signals of the ground wires, and the position change situations of the conductors are further deduced based on the change situations of the mutual inductances between the ground wires and the conductors; and the position information and the movement statuses of the transmission line conductors are online monitored based on the position change situations of the conductors. Therefore, the present disclosure can solve problems of large number of sensors, unsatisfactory monitoring effect, high cost, difficult installation and maintenance in the existing method, may also solve problems of a complex calculation principle and affecting normal operation of the transmission line in case of sensor failures in the existing methods, and may determine changes of the transmission line based on information about the electromagnetic signals of the ground wires and the conductor currents. Meanwhile, the method may realize self-powered online monitoring of the transmission line statuses without any additional power source. The method of the present disclosure uses devices with a small installation volume, and has a low cost of failure and has no influence on the normal operation of the transmission line in case of the failure. The present disclosure provides the online monitoring method for position information of the overhead transmission line conductors based on induced potentials of a segmented insulated ground wire or induced currents of an optical fiber composite overhead ground wire (OPGW), which has advantages of simple principle, low cost, easy installation and maintenance, and high feasibility.

Further, in an embodiment of the disclosure, the position change situation of the conductor includes:
a conductor sag change situation, or a conductor offset situation caused by windage.

Specifically, in an embodiment of the disclosure, online monitoring the conductor sag change situation includes:

analyzing and determining the change situations of the mutual inductances between the ground wires and the conductors by comprehensively considering change situations of conductor currents and the change situations of the monitored ground wire induced potentials or the monitored ground wire induced currents;
deducing change situations of distances between the ground wires and the conductors based on the change situations of the mutual inductances between the ground wires and the conductors;
obtaining the conductor sag change situation by further refining based on the change situations of the distances between the ground wires and the conductors; and
determining based on the conductor sag change situation, and generating an alarm when a conductor maximum sag is greater than a preset threshold.

Further, in an embodiment of the disclosure, a cause of the conductor sag change situation includes increase in transmission capacity of transmission line or conductor ice-over.

Specifically, in an embodiment of the disclosure, when the cause of the conductor sag change situation is the conductor ice-over, the method further includes:
on the basic of considering conductor deformation, obtaining a relationship between horizontal stress and thickness of ice covering the conductor and a relationship between the conductor maximum sag and the thickness of ice covering the conductor by analyzing an influence of an ice gravity respectively on a ratio of a conductor load per unit length to a conductor cross-sectional area, the horizontal stress, and the maximum sag.

Further, in an embodiment of the disclosure, online monitoring the conductor offset situation caused by windage includes:

analyzing and determining the change situations of the mutual inductances between the ground wires and the conductors based on the change situations of the monitored ground wire induced potentials or the monitored ground wire induced currents;
obtaining change situations of distances between the ground wires and the conductors based on the change situations of the mutual inductances between the ground wires and the conductors;
obtaining a spatial position change situation of each conductor by further refining based on the change situations of the distances between the ground wires and the conductors;
deducing the conductor offset situation caused by windage based on the spatial position change situation of the conductor; and
determining based on the conductor offset situation caused by windage, and generating an alarm when a conductor maximum offset is greater than a preset threshold.

Specifically, in an embodiment of the disclosure, the method further includes:
supplying power to the monitoring devices by utilizing the ground wire induced potentials or the ground wire induced currents, to achieve self-power.

Specifically, in an embodiment of the disclosure, the method further includes: online monitoring and locating a galloping situation of the transmission line, in which online monitoring and locating the galloping situation of the transmission line includes:

step S1: obtaining relevant parameters of the overhead transmission line and establishing an equivalent circuit of the ground wires based on the relevant parameters;
step S2: monitoring the electromagnetic signals of the ground wires in real time and performing spectrum analysis on the electromagnetic signals;
step S3: when a frequency abnormal signal is present in the spectrum analysis, sending the frequency abnormal signal to the data processing end and generating an analysis result;
step S4: determining a frequency, a position and an amplitude of galloping of the transmission line based on the analysis result; and
step S5: executing steps S2, S3, and S4 repeatedly and continuously, and generating an alarm when the calculated amplitude of the galloping being greater than a preset threshold.

Further, in an embodiment of the disclosure, determining the frequency, the position and the amplitude of the galloping of the transmission line based on the analysis result includes:

determining the frequency of the conductor galloping;
obtaining phase information of a signal frequency component generated by the corresponding galloping based on the frequency of the conductor galloping;
determining the position of the galloping of the transmission line based on the phase information; and
calculating the amplitude of the galloping based on the position of the galloping of the transmission line and the monitored electromagnetic signals of the ground wires.

During an AC (alternating current) transmission line is operating normally with power on, there is power-frequency current in conductors, which can produce a changing magnetic field in space. When the changing magnetic field acts on a loop formed by "ground wire - earth" or two ground wires, there will be induced potential in the ground wire loop. The induced potential further generates the induced current. The basic principle of this phenomenon is Faraday's law of electromagnetic induction, as shown in FIG. 2, which is expressed as follows:

$$\begin{cases} \oint_l B \cdot \mathrm{d}l = \mu \sum_{k=1}^{n} I_k \\ \varepsilon = -n \dfrac{\Delta \phi}{\Delta t} \end{cases}$$

Taking this law as the basic theory, the present disclosure performs an online monitoring method for position information and movement statuses of transmission line conductors based on electromagnetic signals of ground wires.

The following introduction is made in detail on the online monitoring method for position information of transmission line conductors based on electromagnetic signals of ground wires provided by the present disclosure by taking monitoring conductor ice-over of an overhead transmission line based on the electromagnetic signals of the ground wires as an example.

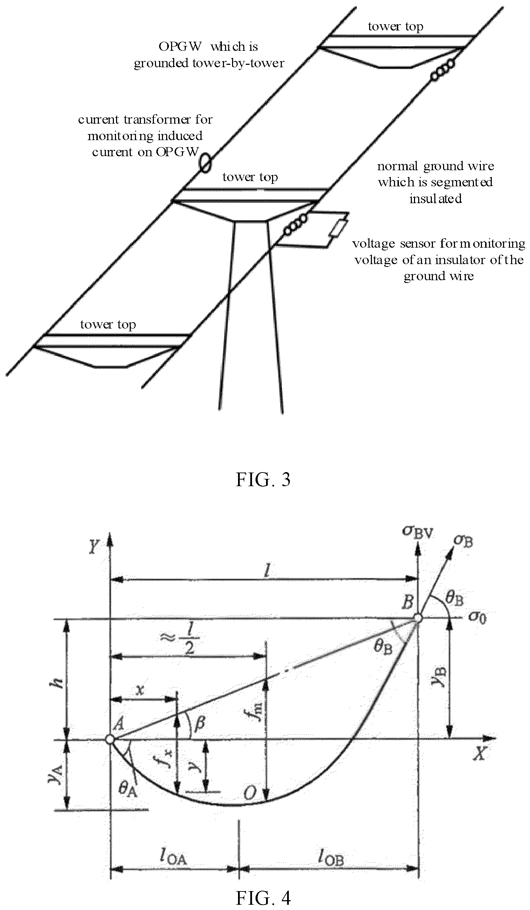

When the transmission line is covered with ice, the conductor sag will change due to an ice gravity and further lead to changes of distances between the ground wires and the conductors, and the mutual inductances between the conductors and the ground wires changes accordingly. The ground wire induced potentials and the ground wire induced currents will also change accordingly when the line currents are fixed. Moreover, the thicker the ice covering the conductor, the greater the changes of the electromagnetic signals of the ground wires. Therefore, the situation of conductor ice-over may be online monitored based on the electromagnetic signals of the ground wires, as shown in FIG. 3.

According to the above contents, this embodiment analyzes and determines the change situations of the mutual inductances between the ground wires and the conductors based on the change situations of the monitored ground wire potentials or the monitored ground wire currents, and then deduces the change situations of the distances between the ground wires and the conductors, and further obtains the conductor sag change situation by refining based on the change situations of the distances between the ground wires and the conductors, and finally deduces the thickness of ice covering the conductor based on the conductor sag change situation.

The change situations of the mutual inductances between the ground wires and the conductors are obtained based on the change situations of the electromagnetic signals of the ground wires, which can be expressed by a first formula:

$$E_G = Z_{GL} I_L,$$

where $E_G$ denotes potential drops per unit length on the ground wires, $Z_{GL}$ denotes mutual impedances between the conductors and the ground wires, and $I_L$ denotes conductor currents.

The change situation of the distance between the conductor and the ground wire is obtained based on the change situation of the mutual inductance between the conductor and the ground wire, which can be expressed by a second formula:

$$Z_{ij} = 0.05 + j\omega \cdot 2 \times 10^{-4} \times \ln \frac{D_g}{d_{ij}} \, (\Omega/\mathrm{km}),$$

where $Z_{ij}$ denotes a mutual impedance between the $i^{\text{th}}$ conductor and the $j^{\text{th}}$ ground wire, $d_{ij}$ denotes a distance between the $i^{\text{th}}$ conductor and the $j^{\text{th}}$ ground wire. $D_g$ denotes a mirror equivalent depth of the $j^{\text{th}}$ ground wire relative to the ground,

$$D_g = 660 \sqrt{\frac{\rho}{f}}$$

with a unit of meter (m), which can be calculated as , where $\rho$ denotes a soil resistivity of the ground ($\Omega \cdot$ m), and $f$ denotes a power-frequency (Hz).

The conductor sag change situation is obtained by refining based on the change situations of the distances between the ground wires and the conductors. When calculating the conductor sag, a catenary model of the conductor is applied. For calculation simplicity, a catenary formula is replaced by a horizontal parabola formula. Taking a suspension point at one end of the conductor as an origin point, as shown in FIG. 4, a third formula is expressed as:

$$y = x \tan \beta - \frac{\gamma x(l - x)}{2\sigma_0} \quad,$$

where, $y$ denotes a vertical position of the conductor at position $x$, $\beta$ denotes a height difference angle, in which $\beta = \dfrac{h}{l}$ ; and h denotes a height difference between two suspension points of the conductor, 1 denotes a length of a span, $\gamma$ denotes a ratio of a conductor load per unit length to a cross-sectional area of the conductor, with a unit of N/(m · $mm^2$), $\sigma_0$ denotes horizontal stress at each point of the conductor, with a unit of N/mm$^2$.

Deducing the thickness of the ice covering the conductor based on the conductor sag change situation includes: on the basic of considering the conductor deformation, obtaining a relationship between horizontal stress and thickness of ice covering a conductor, and a relationship between a conductor sag and thickness of ice covering a conductor by analyzing an influence of an ice gravity respectively on a ratio of a conductor load per unit length to a conductor cross-sectional area, the horizontal stress, and the maximum sag.

Without considering an influence of wind, the ratio of the conductor load per unit length to the conductor cross-sectional area is calculated when the conductor is covered with ice, which can be expressed by a fourth formula:

$$\gamma = \frac{9.8 \times \rho_1 + 9.8 \times 0.9\pi\delta(\delta + d) \times 10^{-3}}{A},$$

where, $\rho_1$ denotes a conductor self-load per unit length, which is a factory known parameter, with a unit of kg / m; $\delta$ denotes the thickness of the ice covering the conductor, with a unit of mm; $d$ denotes a diameter of the conductor, with a unit of mm; $A$ denotes the conductor cross-sectional area, with a unit of mm$^2$.

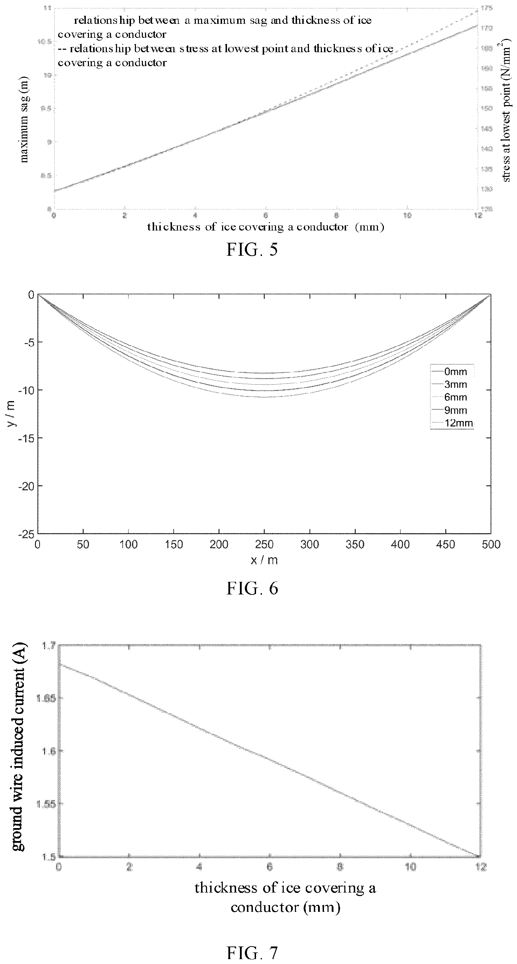

More specifically, during the calculation process, the height difference between the suspension points of the conductor is set as zero, the span of the conductor is set as 500m, conductors are selected as quad bundle JLHA1/GA1-400/95, and specific parameters of the conductors are shown in Table 1. The calculation also uses the relevant simulation software and considers the conductor deformation caused by changes in ice-over and temperature. Based on the above considerations, the relationship between the conductor maximum sag and the thickness of ice covering the conductor as well as the relationship between the horizontal stress at each point of the conductor and the thickness of ice covering the conductor can be obtained, as shown in FIG. 5. The change of the conductor sag with the thickness of ice covering the conductor can be further obtained, as shown in FIG. 6. It can be seen from the calculation result that the conductor maximum sag and the horizontal stress of the conductor increase approximately linearly with the increase of the thickness of ice covering the conductor. After obtaining the change of the conductor sag and the thickness of ice covering the conductor, the change rule of the ground wire induced currents with the thickness of ice covering the conductor can be obtained in combination with the relevant deduction and calculation, as shown in FIG. 7. The connection method of the ground wires in the illustration is that the normal ground wire is segmented insulated and the OPGW is grounded tower by tower.

**Table 1**

| Parameter name | Parameter value |
| --- | --- |
| external diameter (mm) | 29.1 |
| specific weight (kg/km) | 1856.7 |
| spring coefficient (N/mm^2) | 78000 |
| linear expansion coefficient (1/°C*1E-6) | 18 |

After the change relationship of the ground wire induced current with the thickness of ice covering the conductor is obtained, in subsequent practical applications, the thickness of ice covering the conductor can be inversely deduced based on the monitored ground wire induced currents. The monitoring method and effect based on the ground wire induced potentials are similar to those based on the ground wire induced currents.

The following introduction is made in detail on the online monitoring method for position information of transmission line conductors based on electromagnetic signals of ground wires provided by the present disclosure by taking sag monitoring in case of increase in transmission capacity of transmission line based on the electromagnetic signals of the ground wires as an example.

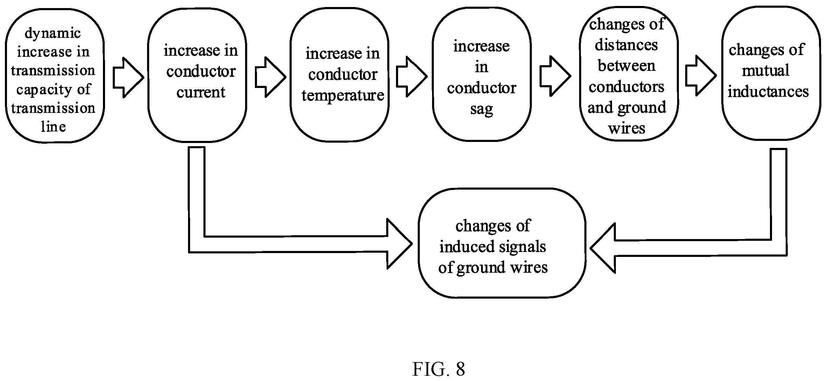

When the transmission line capacity increases, the conductor sag changes due to heat expansion, which leads to the changes of the distances between the conductors and the ground wires. Therefore, the mutual inductances between the conductors and the ground wires change. Consequently, the ground wire induced potentials or the ground wire induced currents will not only change with the line currents, but also change with the conductor sags. Therefore, after obtaining information of the line currents, the conductor sag change situation in a case of increase in transmission capacity of transmission line can be online monitored based on the electromagnetic signals of the ground wires. The schematic diagram of the specific process is shown in FIG. 8.

As can be seen from the above content, the change situations of mutual inductances between the ground wires and the conductors can be deduced based on the values of the operation currents of transmission line and the change situations of the acquired electromagnetic signals of the ground wires. Further, the conductor sag change situation can be deduced through the change situations of the mutual inductances between the ground wires and the conductors. The contents above include:

analyzing and determining the change situations of the mutual inductances between the ground wires and the conductors by comprehensively considering the change situations of the conductor currents and the change situations of the monitored ground wire currents or ground wire potentials in a case of dynamic increase in transmission capacity of transmission line, in which, the change situations of the mutual inductances between the ground wires and the conductors can be obtained according to the change situations of the conductor currents and the change situations of the monitored ground wire currents or ground wire potentials by using a first formula. The first formula is expressed as:

$$E_G = \bar{Z}_{GL} I_L,$$

where $E_G$ denotes potential drops per unit length on the ground wires, $Z_{GL}$ denotes mutual impedances between the conductors and the ground wires, and $I_L$ denotes conductor currents.

Taking a single-circuit transmission line with two ground wires as an example, the first formula can also be expressed as:

$$\begin{bmatrix} E_{g1} \\ E_{g2} \end{bmatrix} = \begin{bmatrix} Z_{g1a} & Z_{g1b} & Z_{g1c} \\ Z_{g2a} & Z_{g2b} & Z_{g2c} \end{bmatrix} \begin{bmatrix} I_a \\ I_b \\ I_c \end{bmatrix},$$

where, $E_{g1}$ denotes a potential drop per unit length on a first ground wire, $E_{g2}$ denotes a potential drop per unit length on a second ground wire, $Z_{g1a}$ denotes a mutual impedance between the first ground wire and a phase $a$ conductor, $Z_{g1b}$ denotes a mutual impedance between the first ground wire and a phase $b$ conductor, $Z_{g1c}$ denotes a mutual impedance between the first ground wire and a phase $c$ conductor, similarly, $Z_{g2a}$ denotes a mutual impedance between the second ground wire and the phase $a$ conductor, $Z_{g2b}$ denotes a mutual impedance between the second ground wire and a phase $b$ conductor, $Z_{g2c}$ denotes a mutual impedance between the second ground wire and a phase c conductor. $I_a$ denotes a current of the phase $a$ conductor, $I_b$ denotes a current of the phase $b$ conductor, and $I_c$ denotes a current of the phase c conductor.

The change situation of the distance between the conductor and the ground wire can be deduced based on the change situation of the mutual inductance between the conductor and the ground wire by using a second formula, which is expressed as:

$$Z_{ij} = 0.05 + j\omega \cdot 2 \times 10^{-4} \times \ln \frac{D_g}{d_{ij}} (\Omega / \mathrm{km}),$$

where $Z_{ij}$ denotes a mutual impedance between the $i^{th}$ conductor and the $j^{th}$ ground wire, $\omega = 2\pi f$, $f$ denotes a frequency of a conductor electronic signal, $D_g$ denotes a mirror equivalent depth of the $j^{th}$ ground wire relative to the ground, with

$$D_g = 660\sqrt{\frac{\rho}{f}}$$

a unit of m, which can be calculated as , where $\rho$ denotes a soil resistivity of the ground ($\Omega \cdot$ m), $d_{ij}$ denotes a distance between the $i^{th}$ conductor and the $j^{th}$ ground wire.

In order to obtain more accurate position information of each point of the conductor, the mutual inductances between the conductors and the ground wires can be calculated by numerical integration during actual calculation and simulation. The mutual impedance can be approximated as equal to a value of the mutual inductance. Taking the mutual impedance between the phase $a$ conductor and the first ground wire as an example, the conductors are divided into n segments, and the mutual impedance between the phase $a$ conductor and the first ground wire can be obtained by accumulating the mutual impedance between each conductor segment and each ground wire segment, which can be expressed as:

$$Z_{g1a} = 0.05 + j\omega \frac{2\times10^{-4}}{n} \sum_{i=0}^{n} ln \frac{D_g}{d_{g1a}(i)} \ (\Omega/km),$$

where $Z_{g1a}$ denotes the mutual impedance between the first ground wire and the phase $a$ conductor, $\omega = 2\pi f$, $f$ denotes a frequency (Hz) of a conductor electronic signal, and $d_{g1a}(k)$ denotes a distance between the $i^{th}$ segment of the phase $a$ conductor and the $i^{th}$ segment of the first ground wire.

The conductor sag change situation may be obtained by further refining based on the change situations of the distances between the ground wires and the conductors by using a third formula, which is expressed as:

$$y = x\tan\beta - \frac{\gamma x(l-x)}{2\sigma_0},$$

where, $y$ denotes a vertical position of the conductor at position $x$, $\beta$ denotes a height difference angle, in which $\tan\beta = \frac{h}{l}$, h denotes a height difference between two suspension points of the conductor, 1 denotes a length of a line span, $\gamma$ denotes a ratio of a conductor load per unit length to a conductor cross-sectional area, with a unit of N/(m - $mm^2$), $\sigma_0$ denotes horizontal stress at each point of the conductor, with a unit of N/mm². When calculating the conductor sag, a catenary model of the conductor is applied. For calculation simplicity, a catenary formula is replaced by a horizontal parabola formula. Taking a suspension point at one end of the conductor as an origin point. A symbol y in FIG. 4 corresponds to y in the first formula, which represents the vertical position of the conductor at each position within the span in a case of selecting one end of a certain segment of conductor (or ground wire). As illustrated in FIG. 4, A and B denote suspension points at two ends of the conductor, O denotes a lowest point of the catenary model of the conductor, namely a maximum sag point, h denotes a height difference between two suspension points of the conductor, I denotes a horizontal distance between two suspension points of the conductor, i.e., the length of the line span, and $f_m$ denotes the conductor maximum sag.

For a certain span of transmission line, the suspension points at two ends of each conductor and each ground wire are fixed. Therefore, the positions of each conductor and each ground wire in the vertical direction can be calculated by the third formula ($\gamma$ and $\sigma_0$ denote two known parameters respectively when the certain span of transmission line operates under normal circumstances) when the transmission line operates normally. Although both of the conductors and the ground wires has sags, relative positions of the conductors and the ground wires are fixed.

During increase in transmission capacity of transmission line, the conductor may experience increase in current, rise in heat generation, and expansion due to heating. Two parameters of $\gamma$ and $\sigma_0$ in the third formula change. The disclosure obtains the change situations of the distances between the ground wires and the conductors based on the change situations of the ground wire induced potentials or the ground wire induced currents. Since the positions of the ground wires are fixed and are calculated by using the third formula initially, the positions of the conductors can be obtained.

Original vertical positions of the conductors and original vertical positions of the ground wires can be calculated by using the third formula, and then the vertical positions of the conductors after the transmission capacity increases can be obtained based on the original vertical positions of the conductors and the changes of the distances between the conductors and the ground wires. Then the conductor sag change situation can be obtained.

In an embodiment of the disclosure, during the calculation process, the height difference between the suspension points at two ends of the conductor is set as zero, the span of the conductor is set as 500m, the conductors are selected as quad bundle JLHA1/GA1-400/95. The specific parameters of the conductors are shown in Table 2.

**Table 2**

| Parameter name | Parameter value |
| --- | --- |
| cross-sectional area (mm^2) | 501.02 |
| external diameter (mm) | 29.1 |
| specific weight (kg/km) | 1856.7 |
| spring coefficient (N/mm^2) | 78000 |
| linear expansion coefficient (1/°C*1E-6) | 18 |

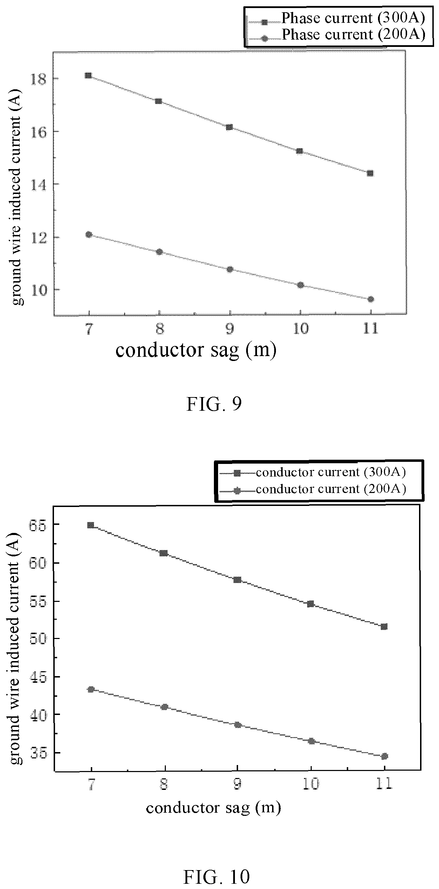

FIG. 9 is a schematic diagram illustrating an influence of a conductor sag in a ground wire induced current when monitoring a conductor sag based on electromagnetic signals of ground wires in case of increase in transmission capacity of transmission line under different phase currents in an embodiment of the disclosure.

The connection method of the ground wires corresponding to FIG. 9 is that two OPGWs are grounded tower by tower. When the conductor current of the transmission line is constant, the ground wire induced current signal decreases approximately linearly with the increasing of the conductor maximum sag. On the basic of this law, the conductor sag change situation may be deduced according to the change situations of the ground wire induced currents.

FIG. 10 is a schematic diagram illustrating an influence of a conductor sag in a potential of a ground wire insulator when monitoring a conductor sag based on electromagnetic signals of ground wires in case of dynamic increase in transmission capacity of transmission line under different phase currents proposed by an embodiment of the disclosure.

The connection method of the ground wires corresponding to FIG. 10 is that the normal ground wire is segmented insulated and the OPGW is grounded tower by tower. When the conductor current is constant, a ground wire induced potential signal decreases approximately linearly with the increasing of the conductor maximum sag. On the basic of this law, the conductor sag change situation may be obtained according to the change situations of the ground wire induced potentials.

After obtaining the relationship of the ground wire induced current changing with the conductor sag under different conductor currents or the relationship of the ground wire induced potential changing with the conductor sag under different conductor currents, the conductor sag change situation for this type of transmission line can be inversely deduced based on the monitored electromagnetic signals of the ground wires in a subsequent practical application.

The following introduction is made in detail on an online monitoring method for position information of transmission line conductors based on electromagnetic signals of ground wires provided by the present disclosure, by taking a method of monitoring the offset caused by windage of the overhead transmission line based on the electromagnetic signals of the ground wires as an example.

When the offset caused by windage occurs in the transmission line, the position offset of each conductor occurs in space with their suspension points as axes and with sags as radii under an action of wind. Therefore, the distances between the conductors and the ground wires change, resulting in the changes of mutual inductances between the conductors and the ground wires. The ground wire induced potentials and the ground wire induced currents will also change accordingly when the line currents are constant. The larger the offset caused by windage, the greater the change in the electromagnetic signals of the ground wires. Therefore, the offset caused by windage of the transmission line can be online monitored based on the electromagnetic signals of the ground wires, as shown in FIG. 3.

As the contents above, in this embodiment, the change situations of the mutual inductances between the ground wires and the conductors are analyzed and determined based on the change situations of the monitored ground wire induced potentials or ground wire induced currents. Further, the change situations of the distances between the ground wires and the conductors are deduced, and then the spatial position change situation of each conductor is obtained by further refining based on the change situations of the distances between the ground wires and the conductors. Finally, the offset situation caused by windage of the transmission line can be deduced based on the spatial position change situation of the conductor. An alarm will be generated when the conductor maximum offset exceeds the preset threshold by determining based on the conduct offset caused by windage.

The change situations of the mutual inductances between the ground wires and the conductors are obtained based on the change situations of the electromagnetic signals of the ground wires, which can be expressed by a first formula:

$$E_G = Z_{GL} I_L,$$

where $E_G$ denotes potential drops per unit length on the ground wires, $Z_{GL}$ denotes mutual impedances per unit length between the conductors and the ground wires, and $I_L$ denotes conductor currents.

The change situation of the distance between the conductor and the ground wire is obtained based on the change situation of the mutual inductance between the conductor and the ground wire, which can be expressed by a second formula:

$$Z_{ij} = 0.05 + j\omega \cdot 2 \times 10^{-4} \times \ln \frac{D_g}{d_{ij}} \, (\Omega / \text{km}),$$

where $Z_{ij}$ denotes a mutual impedance between the $i^{\text{th}}$ conductor and the $j^{\text{th}}$ ground wire, $d_{ij}$ denotes a distance between the $i^{\text{th}}$ conductor and the $j^{\text{th}}$ ground wire, $D_g$ denotes a mirror equivalent depth of the $j^{\text{th}}$ ground wire relative to the ground,

$$D_g = 660 \sqrt{\frac{\rho}{f}},$$

with a unit of meter (m), which can be calculated as                , where $\rho$ denotes a soil resistivity of the ground $(\Omega \cdot m)$, and $f$ denotes a power-frequency (Hz).

When analyzing the change of the distance between the conductor and the ground wire caused by windage, a sag conductor formula is first introduced. Since a distance between two suspension points of the overhead transmission line is large, the conductor rigidity has little influence in the shape of the suspended conductor, the sag conductor formula can be described by a "catenary" model. A third equation is expressed as: $y = \frac{T}{q} \cosh\left(\frac{q}{T}(x - x_0)\right) + y_0$ , where q denotes a per unit load of the conductor, T denotes a tension of the conductor, both of which are parameters related to mechanic; $x_0$ and $y_0$ describe relative positions of the conductor, which can be used to determine origin points of calculation.

Further, the alarm may be generated when the conductor maximum offset exceeds the preset threshold by determining based on the conduct offset caused by windage.

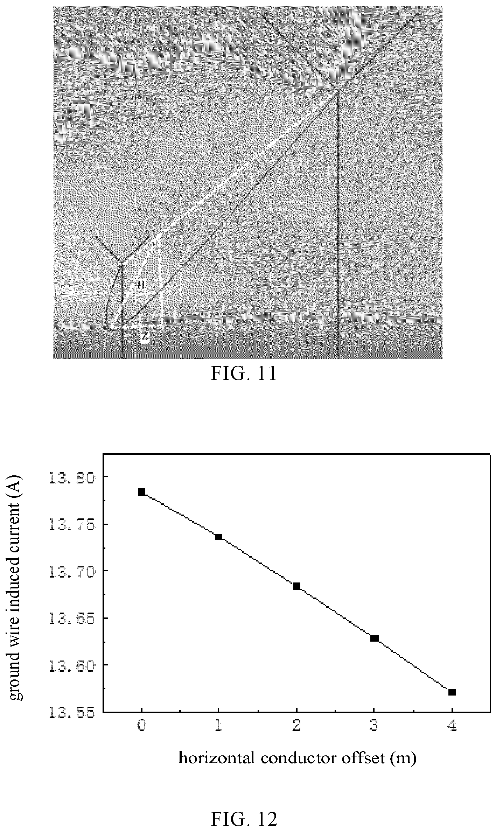

When the conductor offset caused by windage occurs, the conductor can no longer be represented by the form of catenary equation in a plane. Therefore, an "off-angle catenary" model is applied, which represents the conductor deviating a certain distance along the longitudinal direction, as shown in FIG. 11.

In this case, a horizontal offset z is introduced to describe the horizontal offset at the lowest point of the conductor. When z is a positive number, it indicates that the conductor is offset outward, and when z is a negative number, it indicates that the conductor is offset inward. It is assumed that a wind-force acting on each point of the conductor is uniform or not significantly different. Then the relationship between the horizontal offset and the longitudinal offset of the conductor can be described by a white right triangle in FIG. 11. That is, the horizontal offset of each point is linearly related to its longitudinal offset.

The position of the conductor in the span can be determined by two parameters a and z, and the longitudinal offset is expressed as:

$$y = \left[\frac{L}{a}\cosh\left(\frac{a}{L}x - \frac{a}{2}\right) - \frac{L}{a}\cosh\left(\frac{a}{2}\right)\right]\sin\alpha,$$
$$\text{where,} \quad \alpha = \arccos\left(\frac{z}{H}\right) \text{ and } H = \frac{L}{a}\left(\cosh\left(\frac{a}{2}\right) - 1\right).$$

More specifically, during the calculation process, the height difference between the suspension points at two ends of the conductor is set as zero, the span of the transmission line is set as 500m. Conductors are selected as quad bundle JLHA1/GA1-400/95. The specific parameters of the conductors are shown in Table 3. The offset distance of the conductor relative to its original position without wind is used to represent a degree of windage yaw, i.e., a value z in FIG. 11. The ground wire connection method in this example is that the normal ground wire is segmented insulated and OPGW is grounded tower by tower. The influence of the value of z in the ground wire induced current is shown in FIG. 12 (the conductor sag is fixed as 16m). It can be seen from the result that the value of the ground wire induced current is approximately proportional to the conductor horizontal offset during the conductor offset caused by windage.

**Table 3**

| Parameter name | Parameter value |
|---|---|
| cross-section area (mm^2) | 501.02 |
| external diameter (mm) | 29.1 |
| specific weight (kg/km) | 1856.7 |
| spring coefficient (N/mm^2) | 78000 |

After obtaining the relationship of the ground wire induced current changing with the horizontal offset during the conductor offset caused by windage, in subsequent practical applications, the degree of the conductor offset caused by windage for this type of transmission line can be inversely deduced based on the monitored ground wire induced currents. The monitoring method and effect based on the induced potentials of the ground wires are similar to those based on the ground wire induced currents.

The following introduction describes an online monitoring method for position information of transmission line conductors based on electromagnetic signals of ground wires.

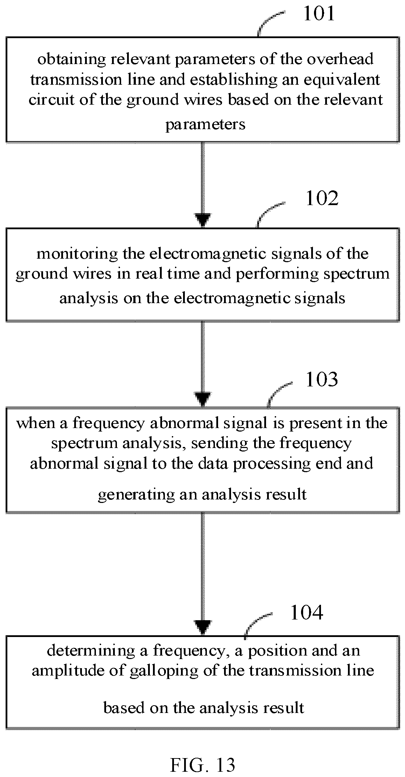

A flowchart illustrating the method for locating galloping of the transmission line based on the electromagnetic signals of the ground wires is provided in this embodiment. As shown in FIG. 13, the method includes the following steps.

At step 101, relevant parameters of the overhead transmission line are obtained, and an equivalent circuit of the ground wires is established based on the relevant parameters.

In this embodiment, the relevant parameters of the overhead transmission line including heights of the ground wires and the conductors respective to the ground, a span, and types of the ground wires and the conductors, etc. are obtained to establish the equivalent circuit of the ground wires. Based on the equivalent circuit of the ground wires, a phase decrease law and an amplitude decrease law of the signals propagating along the ground wires can be deduced when a failure signal occurs, which facilitates the subsequent galloping features deducing and locating.

At step 102, the electromagnetic signals of the ground wires are monitored in real time and spectrum analysis is performed on the monitored electromagnetic signals.

In this embodiment, the electromagnetic signals of the ground wires may include at least one of induced potentials of insulators in the segmented insulated ground wire or induced currents of the OPGW. When the conductors of the transmission line gallop, the vertical positions of the conductors will change periodically, further resulting in a periodical change of the mutual inductances between the conductors and the ground wires. Therefore, the ground wire induced potentials or the ground wire induced currents will change accordingly when the currents of the transmission line are constant.

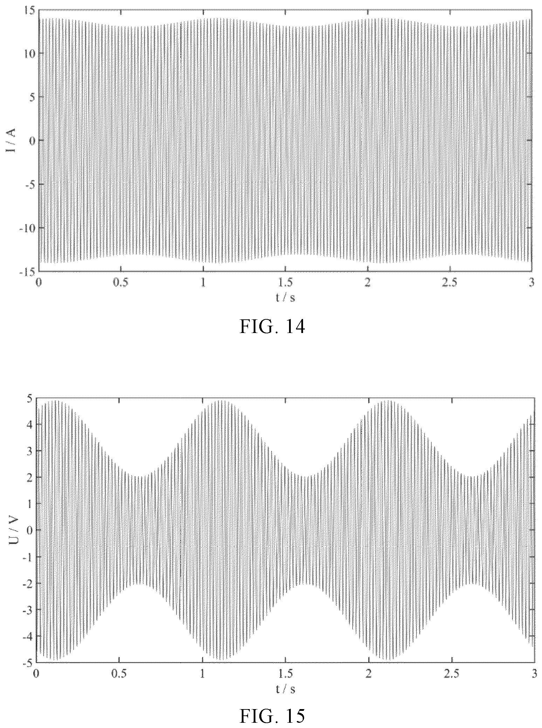

The induced currents on the OPGW can be monitored by current transformers installed on the ground wire. Alternatively, the voltages of insulators in the segmented insulated ground wire can be detected by voltage sensors installed on insulators in the ground wire. That is, the ground wire induced currents or the ground wire induced potentials can be detected in real time by arranging the voltage or current monitoring devices, as shown in FIG. 13 and FIG. 15 respectively. Then the spectrum analysis is performed on the ground wire induced potentials or the ground wire induced currents by obtaining the ground wire induced potentials or the ground wire induced currents.

At step 103, in response to detecting an abnormal frequency signal in the spectrum analysis, the abnormal frequency signal is sent to the data processing end, and an analysis result is generated.

In this embodiment, in a case there is the abnormal frequency component in the electromagnetic signals of the ground wires, that is, there is a galloping-related frequency component coupled to the ground wire induced potentials or the ground wire induced currents, the galloping-related frequency component is an additional low-frequency component coupled to the power-frequency electromagnetic signals when the vertical positions of the conductors change.

When there is no abnormal frequency signal in the circuit parameters, monitoring the electromagnetic signals of the ground wires in real time is continued.

At step 104, a frequency, a position and an amplitude of the galloping of the transmission line are determined based on the analysis result.

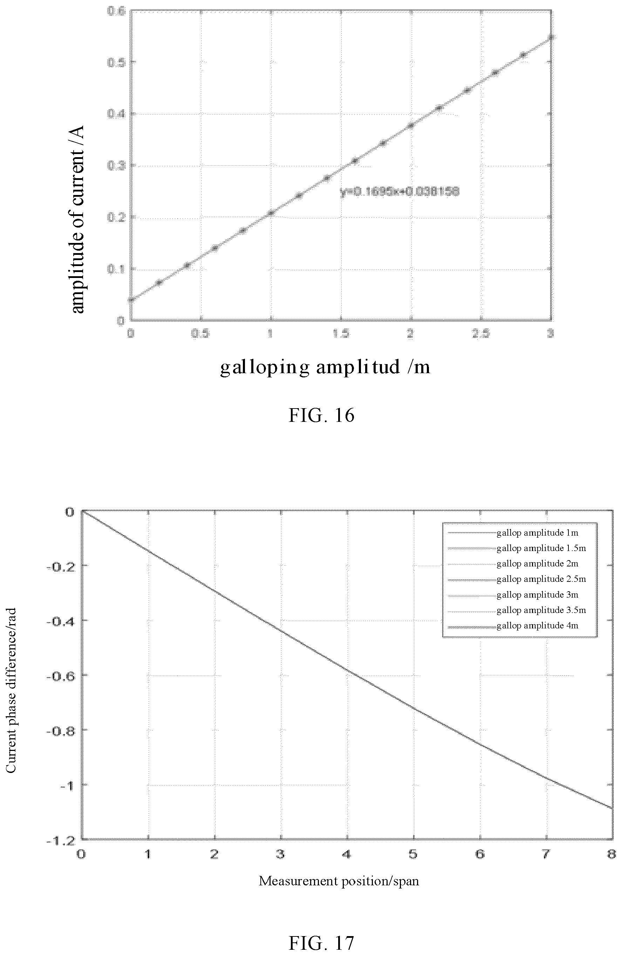

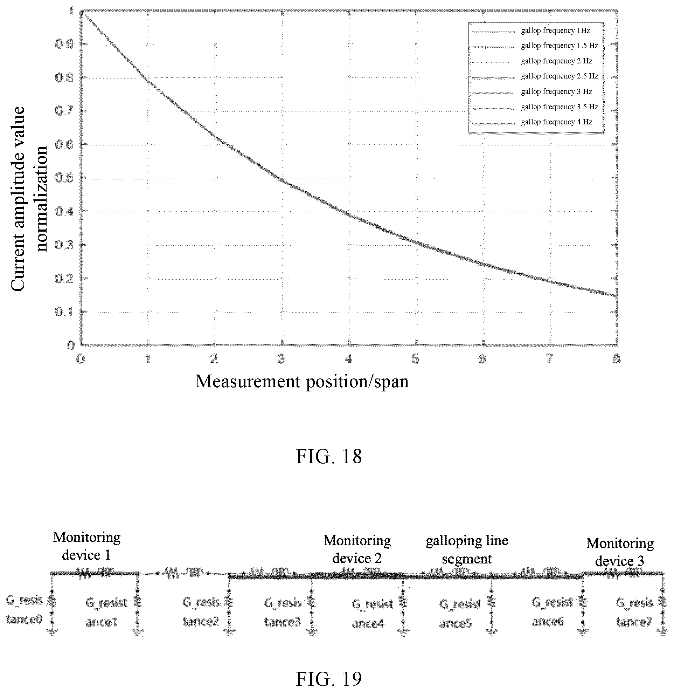

In this embodiment, the frequency component of the galloping can be obtained according to step 103. During the galloping of the transmission line, the component of the galloping of the transmission line can be coupled to on the transmission line. As shown in FIG. 16, it can be seen that an amplitude of the galloping-related frequency component presents a good linear relationship with an amplitude of the galloping. When the conductor currents are constant, amplitudes of galloping-related frequency components coupled to the electromagnetic signals of the ground wires correspond to amplitudes of the galloping one by one. As shown in FIG. 17, the connection method of the ground wires is that the normal ground wire is segmented insulated and the OPGW is grounded tower by tower, the phase of the galloping-related frequency component superimposed on the OPGW current during the galloping changes approximately linearly along the transmission line. Therefore, the monitoring devices can be arranged in a distributed manner according to the above feature, and the span where the galloping occurs can be determined by the subsequent algorithm processing. As shown in FIG. 18, the amplitude of galloping-related frequency component decays along the transmission line. The amplitude of the galloping decays in an exponential law along the transmission line through fitting. For a fixed transmission line, a parameter in an exponential decay expression is fixed. After obtaining the position of the galloping through determination, the amplitude of the galloping at the galloping span can be inversely deduced based on the law in combination with the electromagnetic signals of the ground wires monitored by the distributed monitoring devices as well as the number of spans between the galloping span and each monitoring device.

In detail, determining the frequency, the position and the amplitude of the galloping of the transmission line based on the analysis result includes the followings.

The frequency of the conductor galloping is determined. The frequency and the amplitude of the galloping-related frequency component can be calculated by the matched data processing and communication modules when the galloping frequency component is present in the ground wires.

Phase information of the galloping-related frequency component is obtained based on the frequency of the conductor galloping. When the conductor is galloping, there may be frequency components with $50 \pm f_c$ Hz in the electromagnetic signals of the ground wires, where $f_c$ is the frequency of the conductor galloping. That is, when the galloping occurs, two non-basic frequency components with frequencies significantly higher than other frequencies may be detected during monitoring, and two important parameters of the frequency component are amplitude and phase, therefore, obtaining the phase information refers to calculating the phase of the frequency component with $50 \pm f_c$ Hz.

The position of the galloping of the transmission line is determined based on the phase information of the signal. In a case, the ground wire connection is that the normal ground wire is segmented insulated and the OPGW is grounded tower by tower, the phase of the galloping-related frequency component superimposed on the ground wire induced currents during the galloping changes approximately linearly when propagating along the transmission line. Therefore, the monitoring devices can be arranged in a distributed manner according to the above feature, and the position of the galloping can be determined based on the subsequent algorithm processing.

The amplitude of the galloping is calculated based on the position of the galloping of the transmission line and the monitored electromagnetic signals of the ground wires. As shown in FIG. 18, the amplitude of the galloping exponentially decays along the transmission line. For a fixed transmission line, the parameter in the exponential decay expression is fixed, and the amplitude of the galloping can be determined based on a mathematical expression after the span of the galloping is obtained.

In this embodiment, determining the position of the galloping of the transmission line based on the phase information of the signal includes: determining a position of a device that monitors a maximum feature frequency component; comparing a phase of the monitored feature frequency component with phases of feature frequency components monitored by the neighboring devices on both sides; and determining the position of the galloping of the transmission line based on the law of the phase of the feature signal along the transmission line obtained from the ground wire equivalent circuit. The specific steps are listed as follows.

The position of the device that monitors the maximum feature frequency component is determined. In this embodiment, the position of the device that monitors the maximum feature frequency component is the position closest to the position of the galloping of the transmission line.

The phase of the monitored maximum feature frequency component is compared with the phases of the feature frequency components monitored by the neighboring devices on both sides.

The position of the galloping of the transmission line is determined based on the law of the phase of the feature signal along the transmission line obtained by the ground wire equivalent circuit.

As shown in FIG. 17, the connection method of the ground wires is that the normal ground wire is segmented insulated and the OPGW is grounded tower by tower. the phase of galloping-related frequency component induced on the ground wire induced currents decreases approximately linearly along the transmission line. Therefore, the monitoring devices can be arranged in a distributed manner according to the above feature, and the position of the conductor galloping can be determined based on the subsequent algorithm processing.

In practical applications, the monitoring devices are installed every three spans. In this case, when the phase of the feature component obtained by one monitoring device is the same as the phase of the feature component obtained by another adjacent monitoring device, it indicates that the galloping occurs in the middle of the two monitoring devices. When the phase of the signal obtained by a certain monitoring device has a same difference with phases of the signals monitored by two neighboring monitoring devices, it indicates that the galloping occurs in the span where the certain monitoring device is located.

Assuming that the galloping occurs at more than one span. k is defined as a lag value at each span when the galloping feature signal propagates along the transmission line. FIG. 19 is a schematic diagram illustrating a locating method for multi-span galloping situations.

As shown in FIG. 19, monitoring devices are installed every three spans. For example, when a phase difference of current signals corresponding to the galloping frequency monitored by monitoring devices 1 and 2 is between 2k and 3k, it may be determined that a starting point of the galloping is at the third span. Similarly, when a phase difference of the current signals corresponding to the galloping frequency monitored by monitoring devices 3 and 2 is between 1k and 2k, it may be determined that an ending point of the galloping is at the sixth span. In this way, the galloping interval as shown in a red line segment in FIG. 19 may be determined.

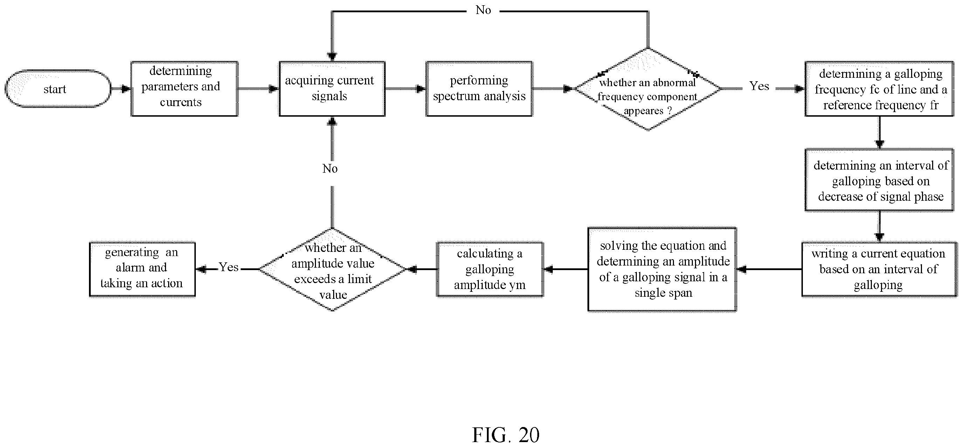

FIG. 20 is a schematic diagram illustrating a locating algorithm for galloping of an overhead transmission line based on electromagnetic signals of ground wires proposed by an embodiment of the disclosure. As shown in FIG. 20, the ground wire induced potentials or ground wire induced currents are monitored in real time by distributed voltage monitoring devices or current monitoring devices on the ground wires of the overhead transmission line, in combination with matched data processing and communication modules. When the ground wire induced potentials or ground wire induced currents are coupled with the galloping-related frequency component, data are sent to the data processing end. The interval of the galloping, the frequency and the amplitude of the galloping are determined according to a galloping recognition and locating algorithm. An alarm is generated when the calculated amplitude of the galloping is greater than a certain threshold. In this embodiment, the position of the galloping of the transmission line is determined based on the position of the device that monitors the maximum feature frequency component, which can realize locating of the galloping without installing the monitoring devices span by span, significantly reduces the cost of monitoring and locating for the galloping.

In order to implement the above embodiments, the disclosure also provides a non-transitory computer readable storage medium which has a computer program stored thereon. When the computer program is executed by a processor, the method of the above embodiments is implemented.

Reference throughout this specification to "an embodiment," "some embodiments," "an example," "a specific example," or "some examples," means that a particular feature, structure, material, or characteristic described in combination with the embodiment or example is included in at least one embodiment or example of the disclosure. The appearances of the above phrases in various places throughout this specification are not necessarily referring to the same embodiment or example of the disclosure. Furthermore, the particular features, structures, materials, or characteristics may be combined in any suitable manner in one or more embodiments or examples. In addition, different embodiments or examples and features of different embodiments or examples described in the specification may be combined by those skilled in the art without mutual contradiction.

In addition, terms such as "first" and "second" are used herein for purposes of description and are not intended to indicate or imply the relative importance or implicitly specify the number of technical features indicated. Therefore, the feature defined with "first" and "second" may explicitly or implicitly include at least one such feature. In the description of the disclosure, "a plurality of" means at least two, for example, two or three, unless specified otherwise.

Any process or method described in a flowchart or described herein in other ways may be understood to include one or more modules, or portions of codes of executable instructions for achieving specific logical functions or steps in the process, the scope of a preferred embodiment of the disclosure includes other implementations, and functions may be performed in a substantially simultaneous order or a reverse order in addition to the order shown or discussed depending on the function involved, which should be understood by those skilled in the art.

The logic and/or step described in other manners herein or shown in the flowchart, for example, a particular sequence table of executable instructions for realizing the logical function, may be specifically achieved in any computer readable medium to be used by the instruction execution system, device or equipment (such as the system based on computers, the system comprising processors or other systems capable of obtaining the instruction from the instruction execution system, device and equipment and executing the instruction), or to be used in combination with the instruction execution system, device and equipment. As to the specification, "the computer readable medium" may be any device adaptive for including, storing, communicating, propagating or transferring programs to be used by or in combination with the instruction execution system, device or equipment. More specific examples of the computer readable medium include but are not limited to: an electronic connection (an electronic device) with one or more wires, a portable computer enclosure (a magnetic device), a Random Access Memory (RAM), a Read Only Memory (ROM), an Erasable Programmable Read-Only Memory (EPROM or a flash memory), an optical fiber device and a portable Compact Disk Read-Only Memory (CDROM). In addition, the computer readable medium may even be a paper or other appropriate medium capable of printing programs thereon, this is because, for example, the paper or other appropriate medium may be optically scanned and then edited, decrypted or processed with other appropriate methods when necessary to obtain the programs in an electric manner, and then the programs may be stored in the computer memories.

It should be understood that each part of the disclosure may be realized by the hardware, software, firmware or their combination. In the above embodiments, a plurality of steps or methods may be realized by the software or firmware stored in the memory and executed by the appropriate instruction execution system. For example, if it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a Programmable Gate Array (PGA), a Field Programmable Gate Array (FPGA), etc.

It would be understood by those skilled in the art that all or a part of the steps carried by the method in the above-described embodiments may be completed by relevant hardware instructed by a program. The program may be stored in a computer readable storage medium. When the program is executed, one step or a combination of the steps of the method in the above-described embodiments may be completed.

In addition, individual functional units in the embodiments of the disclosure may be integrated in one processing module or may be physically separated, or two or more units may be integrated in one module. The integrated module as described above may be achieved in the form of hardware, or may be achieved in the form of a software functional module. If the integrated module is achieved in the form of a software functional module and sold or used as a separate product, the integrated module may also be stored in a computer readable storage medium.

The storage medium mentioned above may be ROMs, magnetic disks or CD, etc. Although explanatory embodiments have been shown and described, it would be appreciated by those skilled in the art that the above embodiments are exemplary and are not to be construed as limiting the disclosure, and changes, modifications, alternatives, and modifications can be made in the embodiments without departing from scope of the disclosure.

**Claims**

1. An online monitoring method for position information of transmission line conductors based on electromagnetic signals of ground wires, comprising:

   monitoring ground wire induced potentials or ground wire induced currents in real time by voltage monitoring devices or current monitoring devices on ground wires of an overhead transmission line in combination with matched data processing and communication modules;
   in response to changing in the ground wire induced potentials or the ground wire induced currents, sending values of the ground wire induced potentials or the ground wire induced currents before and after changing to a data processing end, after determination of a related module;
   deducing change situations of mutual inductances between the ground wires and the conductors based on values of line operation currents and change situations of electromagnetic signals of the ground wires, and further deducing position change situations of the conductors based on the change situations of the mutual inductances between the ground wires and the conductors; and
   online monitoring position information and movement statuses of the transmission line conductors based on the position change situations of the conductors.

2. The method of claim 1, wherein the position change situation of the conductor comprises:
   a conductor sag change situation, or a conductor offset situation caused by windage.

3. The method of claim 2, wherein online monitoring the conductor sag change situation comprises:

   analyzing and determining the change situations of the mutual inductances between the ground wires and the conductors by comprehensively considering change situations of conductor currents and the change situations of the monitored ground wire induced potentials or the monitored ground wire induced currents;
   deducing change situations of distances between the ground wires and the conductors based on the change situations of the mutual inductances between the ground wires and the conductors;
   obtaining the conductor sag change situation by further refining based on the change situations of the distances between the ground wires and the conductors; and
   determining based on the conductor sag change situation, and generating an alarm when a conductor maximum sag is greater than a preset threshold.

4. The method of claim 3, wherein a cause of the conductor sag change situation comprises increase in transmission capacity of transmission line or conductor ice-over.

5. The method of claim 4, wherein when the cause of the conductor sag change situation is the conductor ice-over, the method further comprises:
   on the basic of considering conductor deformation, obtaining a relationship between horizontal stress and thickness of ice covering the conductor and a relationship between the conductor maximum sag and the thickness of ice covering the conductor by analyzing an influence of an ice gravity respectively on a ratio of a conductor load per unit length to a conductor cross-sectional area, the horizontal stress, and the maximum sag.

6. The method of claim 2, wherein online monitoring the conductor offset situation caused by windage comprises:

   analyzing and determining the change situations of the mutual inductances between the ground wires and the conductors based on the change situations of the monitored ground wire induced potentials or the monitored ground wire induced currents;

   obtaining change situations of distances between the ground wires and the conductors based on the change situations of the mutual inductances between the ground wires and the conductors;

   obtaining a spatial position change situation of each conductor by further refining based on the change situations of the distances between the ground wires and the conductors;

   deducing the conductor offset situation caused by windage based on the spatial position change situation of the conductor; and

   determining based on the conductor offset situation caused by windage, and generating an alarm when a conductor maximum offset is greater than a preset threshold.

7. The method of claim 1, further comprising:
   supplying power to the monitoring devices by utilizing the ground wire induced potentials or the ground wire induced currents, to achieve self-power.

8. The method of claim 1, further comprising: online monitoring and locating a transmission line galloping situation, wherein online monitoring and locating the transmission line galloping situation comprises:

   step S1: obtaining relevant parameters of the overhead transmission line and establishing an equivalent circuit of the ground wires based on the relevant parameters;

   step S2: monitoring the electromagnetic signals of the ground wires in real time and performing spectrum analysis on the electromagnetic signals;

   step S3: when a frequency abnormal signal is present in the spectrum analysis, sending the frequency abnormal signal to the data processing end and generating an analysis result;

   step S4: determining a frequency, a position and an amplitude of galloping of the transmission line based on the analysis result; and

   step S5: executing steps S2, S3, and S4 repeatedly and continuously, and generating an alarm when the calculated amplitude of the galloping being greater than a preset threshold.

9. The method of claim 8, wherein determining the frequency, the position and the amplitude of the galloping of the transmission line based on the analysis result comprises:

   determining the frequency of the conductor galloping;

   obtaining phase information of a signal frequency component generated by the corresponding galloping based on the frequency of the conductor galloping;

   determining the position of the galloping of the transmission line based on the phase information; and

   calculating the amplitude of the galloping based on the position of the galloping of the transmission line and the monitored electromagnetic signals of the ground wires.

10. A non-transitory computer-readable storage medium having a computer program stored thereon, wherein when the computer program is executed by a processor, the method according to any one of claims 1 to 9 is implemented.

monitoring ground wire induced potentials or ground wire induced currents in real time by voltage monitoring devices or current monitoring devices on ground wires of an overhead transmission line in combination with matched data processing and communication modules ⟶ 101

in response to changing in the ground wire induced potentials or the ground wire induced currents, sending values of the ground wire induced potentials or the ground wire induced currents before and after changing to a data processing end, after determination of a related module ⟶ 102

deducing change situations of mutual inductances between the ground wires and the conductors based on values of line operation currents and change situations of electromagnetic signals of the ground wires, and further deducing position change situations of the conductors based on the change situations of the mutual inductances between the ground wires and the conductors ⟶ 103

online monitoring position information and movement statuses of the transmission line conductors based on the position change situations of the conductors ⟶ 104

FIG. 1

FIG. 2

FIG. 3

FIG. 4

FIG. 5

FIG. 6

FIG. 7

```
┌─────────────┐      ┌─────────────┐      ┌─────────────┐      ┌─────────────┐      ┌─────────────┐      ┌─────────────┐
│  dynamic    │      │             │      │             │      │             │      │ changes of  │      │             │
│ increase in │      │ increase in │      │ increase in │      │  increase   │      │  distances  │      │ changes of  │
│transmission │  ⇨  │  conductor  │  ⇨  │  conductor  │  ⇨  │     in      │  ⇨  │  between    │  ⇨  │   mutual    │
│ capacity of │      │   current   │      │ temperature │      │  conductor  │      │ conductors  │      │ inductances │
│transmission │      │             │      │             │      │     sag     │      │ and ground  │      │             │
│    line     │      │             │      │             │      │             │      │   wires     │      │             │
└─────────────┘      └─────────────┘      └─────────────┘      └─────────────┘      └─────────────┘      └─────────────┘
```

changes of
induced signals
of ground wires

FIG. 8

FIG. 9

FIG. 10

FIG. 11

FIG. 12

101

obtaining relevant parameters of the overhead
transmission line and establishing an equivalent
circuit of the ground wires based on the relevant
parameters

102

monitoring the electromagnetic signals of the
ground wires in real time and performing spectrum
analysis on the electromagnetic signals

103

when a frequency abnormal signal is present in the
spectrum analysis, sending the frequency
abnormal signal to the data processing end and generating an analysis result

104

determining a frequency, a position and an
amplitude of galloping of the transmission line based on the analysis result

FIG. 13

FIG. 14

FIG. 15

FIG. 16

FIG. 17

FIG. 18

FIG. 19

FIG. 20

## INTERNATIONAL SEARCH REPORT

| | International application No. |
|---|---|
| | **PCT/CN2022/092079** |

**A.    CLASSIFICATION OF SUBJECT MATTER**

G01B 7/00(2006.01)i

According to International Patent Classification (IPC) or to both national classification and IPC

**B.    FIELDS SEARCHED**

Minimum documentation searched (classification system followed by classification symbols)

G01B; G01R; G01D

Documentation searched other than minimum documentation to the extent that such documents are included in the fields searched

Electronic data base consulted during the international search (name of data base and, where practicable, search terms used)

CNTXT; ENTXTC; ENTXT; VEN; CJFD; WFNPL, CNKI, IEEE: 地线, 导线, 接地, 电磁, 感应, 互感, 监测, 检测, 弧垂, 舞动, 风偏, 电流, 电磁感应, 电压, 位置, 变化, 改变, 自供电, 取能, 在线, electromagnetic, induct+, voltage, current, change, sag, windage, galloping, self-powered, position, monitor+, ground wire

**C.    DOCUMENTS CONSIDERED TO BE RELEVANT**

| Category* | Citation of document, with indication, where appropriate, of the relevant passages | Relevant to claim No. |
|---|---|---|
| PX | CN 114396860 A (TSINGHUA UNIVERSITY) 26 April 2022 (2022-04-26)<br>claims 1-7 | 1-4, 7, 10 |
| PX | CN 114384352 A (TSINGHUA UNIVERSITY) 22 April 2022 (2022-04-22)<br>claims 1-7 | 1-5, 7, 10 |
| PX | CN 114396859 A (TSINGHUA UNIVERSITY) 26 April 2022 (2022-04-26)<br>claims 1-7 | 1-2, 6-7, 10 |
| PX | CN 114295196 A (TSINGHUA UNIVERSITY) 08 April 2022 (2022-04-08)<br>claims 1-10 | 1, 8-10 |
| X | CN 109000716 A (TSINGHUA UNIVERSITY) 14 December 2018 (2018-12-14)<br>description, paragraphs 4-17 and 28-49 | 1-8, 10 |
| X | CN 108801442 A (TSINGHUA UNIVERSITY) 13 November 2018 (2018-11-13)<br>description, paragraphs 4-17 and 28-48 | 1-8, 10 |
| A | CN 110221180 A (ELECTRIC POWER RESEARCH INSTITUTE, STATE GRID SICHUAN ELECTRIC POWER CO., LTD.) 10 September 2019 (2019-09-10)<br>entire document | 1-10 |

| ☑ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 July 2022** | **12 August 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2022/092079** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP H08189949 A (HITACHI CABLE LTD.) 23 July 1996 (1996-07-23)<br>entire document | 1-10 |

Form PCT/ISA/210 (second sheet) (January 2015)

**INTERNATIONAL SEARCH REPORT**
Information on patent family members

International application No.

**PCT/CN2022/092079**

| Patent document cited in search report | | | Publication date (day/month/year) | Patent family member(s) | | | Publication date (day/month/year) |
|---|---|---|---|---|---|---|---|
| CN | 114396860 | A | 26 April 2022 | None | | | |
| CN | 114384352 | A | 22 April 2022 | None | | | |
| CN | 114396859 | A | 26 April 2022 | None | | | |
| CN | 114295196 | A | 08 April 2022 | None | | | |
| CN | 109000716 | A | 14 December 2018 | CN | 109000716 | B | 02 June 2020 |
| CN | 108801442 | A | 13 November 2018 | CN | 108801442 | B | 23 August 2019 |
| CN | 110221180 | A | 10 September 2019 | CN | 110221180 | B | 06 July 2021 |
| JP | H08189949 | A | 23 July 1996 | None | | | |

Form PCT/ISA/210 (patent family annex) (January 2015)